# EUROPÄISCHE PATENTSCHRIFT

(11) **EP 2 916 391 B1**
(45) Veröffentlichungstag und Bekanntmachung des Hinweises auf die Patenterteilung: **08.08.2018**
(21) Anmeldenummer: 15158117.0
(22) Anmeldetag: 06.03.2015
(51) Int. Cl.: H05K 1/14, H05K 3/36, H01R 12/61, H01R 12/52, H01R 12/62

(54) **Leiterplattenanordnung mit flexiblem Verbindungselement**
Circuit card assembly with a flexible connecting element
Assemblage de plaques à circuits avec un élément de connexion flexible

(30) Priorität: 07.03.2014 DE 102014103040
(43) Veröffentlichungstag der Anmeldung: 09.09.2015
(73) Patentinhaber: Neuschäfer Elektronik GmbH, 35066 Frankenberg (DE)
(72) Erfinder: Neuschäfer, Wilfried, 35066 Frankenberg (DE)
(74) Vertreter: Patentanwälte Olbricht Buchhold Keulertz

(56) Entgegenhaltungen:
- DE-A1-102004 022 456
- DE-A1-102011 119 842
- DE-A1-102012 007 076
- DE-U1- 7 704 585
- DE-U1-202004 021 564

## Beschreibung

Die Erfindung betrifft eine Leiterplattenanordnung mit mindestens einem flexiblen Verbindungselement gemäß dem Oberbegriff von Anspruch 1. In der Elektronik werden die elektrischen Bauelemente auf Leiterplatten angeordnet, die in der Regel elektrisch leitende, festhaftende Verbindungen als Leiter aufweisen, die in oder auf einem Isolierstoff ein- oder mehrschichtig auf- beziehungsweise eingebracht worden sind. Dabei dienen die Leiterplatten üblicherweise auch als Träger für Anzeige-, Bedien- oder Stellglieder einer elektronischen Schaltung, die für einen Benutzer zugänglich angeordnet sein müssen.

Um dichte Bestückungen zu ermöglichen, werden die einzelnen Bauelemente häufig als oberflächenmontierbare Bauelemente (SMD) ausgebildet, die mittels einer speziellen Oberflächenmontagetechnik (SMT) in Bestückungslinien auf den Oberflächen der Leiterplatten aufgebracht werden. Oberflächenmontierbare Bauelemente besitzen üblicherweise keine Drahtanschlüsse, sondern sind mit Lötflächen versehen, mit denen sie mittels Lötpaste auf entsprechenden Anschlussflächen der Leiterplatten verlötet werden. Durch den Verzicht auf Drahtanschlüsse, die beispielsweise bei Bauelementen zur Durchsteckmontage (through-hole technology = THT) verwendet werden können, weisen die oberflächenmontierbaren Bauelemente eine verringerte Baugröße auf. Darüber hinaus ist auch eine beidseitige Bestückung der Leiterplatten relativ einfach möglich.

Die räumlichen Verhältnisse für die Unterbringung einer Leiterplatte sind häufig sehr beengt, beispielsweise wenn die Leiterplatte in einem kleinen Gehäuse untergebracht werden soll oder das Gehäuse in mehrere Bereiche unterteilt ist. Auch ist es häufig schwierig, Anzeige- und/oder Bedienelemente derart unterzubringen, dass sie für einen Benutzer leicht zugänglich sind. Häufig werden diese Bauelemente dann auf einer zusätzlichen Leiterplatte angeordnet, die in einer unterschiedlichen Raumrichtung gegenüber der übrigen Schaltung angeordnet wird. Dies kann dazu führen, dass die einzelnen Bauteile der elektronischen Schaltung auf mehrere Leiterplatten verteilt sind.

Diese Leiterplatten werden dann über separate Verbindungselemente wie zum Beispiel mehrpolige Steckverbinder oder flexible Verbindungselemente wie Flachkabel, die auch Jumper genannt werden, miteinander verbunden. Insbesondere die Formbarkeit der flexiblen Verbindungselemente ermöglicht es dann, starre Leiterplatten aus einer Ebene heraus in eine dritte Dimension zu führen.

Ein häufiges Problem bei flexiblen Verbindungselementen, die üblicherweise einen streifenförmigen Grundkörper aufweisen, der in seinen Endbereichen über jeweils eine Lötfläche verlötet wird, stellt die Herstellung einer reproduzierbaren Verformung dar. Darüber hinaus kann es beim Biegevorgang zum Abscheren der Lötverbindung und damit zu einer Beschädigung der elektrischen Verbindung kommen. Die Druckschrift DE202004021564U1 offenbart eine Leiterplattenanordnung gemäß dem Oberbegriff des Anspruchs 1.

Der Erfindung liegt nun die Aufgabe zugrunde, die Nachteile des Standes der Technik zu beseitigen und insbesondere ein flexibles Verbindungselement anzugeben, das eine räumliche Bewegung zweier Leiterplatten zueinander ermöglicht, wobei das Verbindungselement reproduzierbar verformbar ist. Darüber hinaus soll das Risiko, die über das flexible Verbindungselement hergestellte elektrisch leitende Verbindung beim Umformen zu beschädigen, minimiert werden.

Erfindungsgemäß wird diese Aufgabe durch eine Leiterplattenanordnung mit den Merkmalen des Anspruchs 1 gelöst. Vorteilhafte Ausgestaltungen finden sich in den Unteransprüchen.

Bei einem flexiblen Verbindungselement mit mindestens einem elektrisch leitfähigen Grundkörper, der streifenförmig ausgebildet ist und in seinen Endbereichen jeweils eine Lötfläche aufweist, ist erfindungsgemäß vorgesehen, dass im Grundkörper zwei Durchbrüche ausgebildet sind, die auf einer Längsachse des Grundkörpers und beidseitig einer senkrecht zur Längsachse verlaufenden Querachse liegen.

Mithilfe dieser Durchbrüche ist die Ausbildung einer zusätzlichen Lötverbindung zwischen dem flexiblen Verbindungselement und den Leiterplatten möglich, wobei die zusätzliche Lötverbindung im Bereich der Durchbrüche die an den Lötflächen ausgebildete Lötverbindung gegenüber Scherkräften schützt, die beim Biegen des Verbindungselementes auftreten. Dabei sind die Durchbrüche in Richtung der potenziellen Biegelinie, die parallel zur Querachse verläuft, gegenüber den Lötflächen nach innen versetzt. Bei dem erfindungsgemäßen Verbindungselement handelt es sich dabei um einen Jumper oder Flachleiterverbinder aus einem entsprechend elastischen, gegebenenfalls auch plastisch verformbaren Material. Dabei ist das flexible Verbindungselement als oberflächenmontierbares Bauelement ausgebildet, das insbesondere mittels Reflow-Lötverfahren auf der Leiterplatte befestigt wird.

In einer bevorzugten Weiterbildung verläuft die Längsachse mittig zum Grundkörper, wobei die Durchbrüche im gleichen Abstand zur Querachse angeordnet sind, die insbesondere ebenfalls mittig zum Grundkörper verläuft. Die Durchbrüche sind also symmetrisch angeordnet. Damit wird ausgenutzt, dass die beim Biegen auftretenden Kraftlinien, die von der im jeweiligen Durchbruch angeordneten Lötverbindungen ausgehen, symmetrisch in Richtung der Querachse aufeinander zu laufen. Damit tritt eine Verformung beim Biegen gezielt im Bereich der Querachse auf. Durch die Durchbrüche und die darin befindliche Lötverbindung wird also eine gezielte, gleichmäßige und reproduzierbare Verformung des flexiblen Verbindungselementes ermöglicht, ohne dass zusätzliche Maßnahmen, wie beispielsweise Materialschwächungen, vorgenommen werden müssen.

Bevorzugterweise liegen die Durchbrüche außerhalb der Lötflächen. Durch die in den Durchbrüchen ausgebildete Lötverbindung beim montierten flexiblen Verbindungselement werden die Lötverbindungen im Bereich der Lötflächen dann zusätzlich geschützt.

Vorzugsweise sind die Durchbrüche kreisförmig ausgebildet. Dies stellt eine besonders einfache Ausgestaltung dar und ermöglicht darüber hinaus eine symmetrische Einleitung der Kraftlinien, ohne dass es zu Spannungsrissen oder Ähnlichem im Grundkörper kommt.

In einer bevorzugten Weiterbildung ist ein mittlerer Bereich des Grundkörpers außerhalb der Lötflächen mit einer Folie bedeckt, wobei die Folie im Bereich der Durchbrüche Öffnungen aufweist. Die Öffnungen dienen dabei zum Einbringen des Lötmaterials. Die Folie dient beispielsweise zur elektrischen Isolierung und zum Schutz des Grundkörpers vor mechanischen Einflüssen. Auch kann durch eine derartige Folie die Handhabung des Verbindungselementes während des Bestückens der Leiterplatten vereinfacht werden.

Bei bevorzugten Ausführungsformen weist der Grundkörper an seinen Enden jeweils mindestens einen Einsteckpin auf. Das flexible Verbindungselement stellt damit eine Kombination eines oberflächenmontierbaren Bauelements mit einem drahtgebundenen Bauelement dar. Dabei kann der Einsteckpin einen zusätzlichen elektrischen Kontakt zu Leiterbahnen auf der Leiterplatte herstellen. Er dient aber in erster Linie zur genauen Positionierung des Verbindungselementes während des Bestückungsvorgangs und der Erwärmung der Lötpaste. Das Problem des Aufschwimmens, das beispielsweise beim "Reflow-Löten" oder Wiederaufschmelzlöten auftreten kann, wird so vermieden. Der Einsteckpin ermöglicht also eine höhere Strombelastbarkeit des Verbindungselementes und erlaubt darüber hinaus eine sehr genaue Positionierung.

Vorzugsweise ist der Einsteckpin einstückig mit dem Grundkörper ausgebildet. Dies stellt eine besonders einfache Herstellungsvariante dar. Dabei befindet sich der Einsteckpin üblicherweise an den Enden des Grundkörpers und kann einfach umgebogen werden, sodass der Einsteckpin im Wesentlichen senkrecht zum Grundkörper verläuft.

Vorzugsweise liegen die Einsteckpins mit den Durchbrüchen auf einer Längsachse. Das gesamte Verbindungselement kann so symmetrisch zu dieser Längsachse aufgebaut werden.

Ein einfacher Aufbau des Verbindungselementes ergibt sich dadurch, dass Längsseiten des Grundkörpers parallel zur Längsachse verlaufen. Der Grundkörper kann dann im Wesentlichen rechteckig ausgebildet sein.

In einer bevorzugten Weiterbildung weist der Grundkörper an seinen Enden winklig zusammenlaufende Kanten auf. Der Grundkörper weist also keine strenge Rechteckgeometrie auf, sondern läuft an seinen schmalseitigen Enden dreieckig zusammen. Dabei sind die Einsteckpins bevorzugterweise am Schnittpunkt der Kanten ausgebildet.

Bei einer erfindungsgemäßen Leiterplattenanordnung ist vorgesehen, dass die Leiterplattenanordnung mindestens zwei durch einen Spalt getrennte Leiterplatten aufweist, der von der Verbindung überbrückt ist, wobei das Verbindungselement mit jeweils einer Lötfläche auf einer Anschlussfläche der Leiterplatten verlötet ist und in den Durchbrüchen jeweils eine zusätzliche Lötverbindung ausgebildet ist. Die Lötverbindung zwischen den Lötflächen und den Anschlussflächen sowie in den Durchbrüchen kann dabei mittels Schmelzlöten hergestellt werden, sodass das Verbindungselement oberflächenmontierbar bleibt. Dabei schützt die zusätzliche Lötverbindung im Bereich der Durchbrüche die zwischen den Lötflächen und der Anschlussfläche ausgebildete Hauptlötverbindung, die den wesentlichen elektrischen Kontakt herstellt. Insbesondere beim Biegen des Verbindungselementes wird das Risiko einer Beschädigung so minimiert. Darüber hinaus führt die zusätzliche Lötverbindung zur gezielten Einleitung von Kraftlinien in das Verbindungselement, sodass eine definierte Biegelinie erhalten wird. Damit wird eine reproduzierbare Verformung mit definierter Endlage der Leiterplatten ermöglicht.

In einer bevorzugten Ausgestaltung sind die Einsteckpins in Einstecköffnungen, die in den Leiterplatten ausgebildet sind, eingeführt. Die Vorteile der oberflächenmontierbaren Bauelemente werden damit mit drahtgebundenen Bauelementen kombiniert. Die Einsteckpins sichern das Verbindungselement während des Schmelzlötens und können zusätzlich eine weitere elektrische Verbindung herstellen. Damit ergibt sich eine genauere Positionierung sowie eine höhere Strombelastbarkeit.

Die Erfindung wird im Folgenden anhand bevorzugter Ausführungsbeispiele in Verbindung mit den Zeichnungen näher beschrieben. Hierin zeigen:
- Figur 1: eine Draufsicht auf ein Verbindungselement,
- Figur 2: das Verbindungselement mit eingezeichneten Kraftlinien und
- Figur 3: eine dreidimensionale Ansicht eines Verbindungselementes mit zwei Grundkörpern.

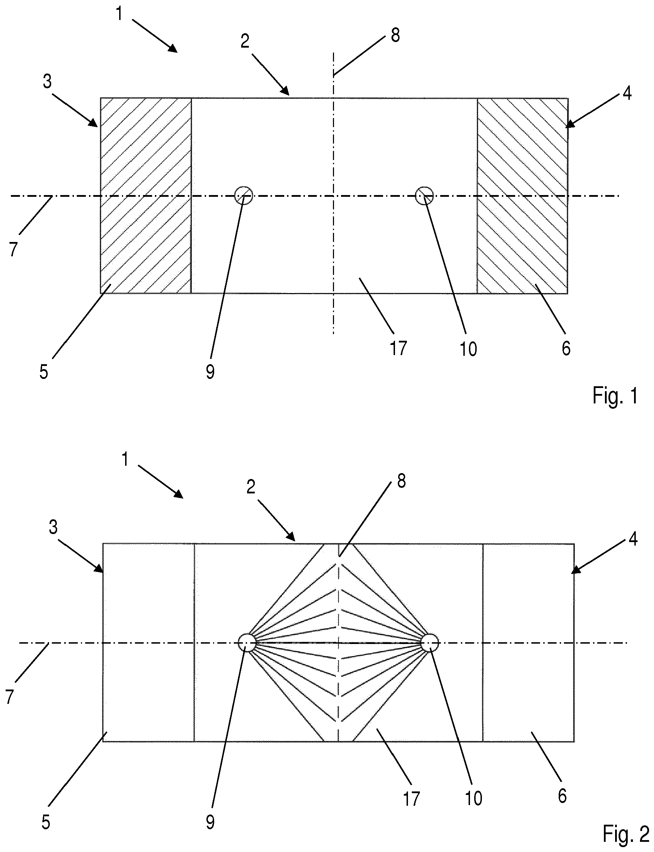

In Figur 1 ist ein flexibles Verbindungselement 1 dargestellt, das einen Flachleiterverbinder oder Jumper darstellt. Das flexible Verbindungselement 1 weist einen rechteckigen, elektrisch leitfähigen Grundkörper 2 auf, der im Bereich seiner Enden 3, 4 Lötflächen 5, 6 aufweist. Auf einer mittigen Längsachse 7 des Grundkörpers 2 und im gleichen Abstand d zu einer senkrecht zur Längsachse 7 verlaufenden Querachse 8, die ebenfalls mittig den Grundkörper 2 teilt, sind im Grundkörper 2 zwei Durchbrüche 9, 10 ausgebildet, durch die eine zusätzliche Lötverbindung zwischen dem flexiblen Verbindungselement 1 und einer Leiterplatte erfolgen kann. Die Durchbrüche 9, 10 liegen dabei außerhalb der Lötflächen 5, 6 und sind gegenüber den Lötflächen 5, 6 nach innen versetzt.

In Figur 2 sind nun die beim Biegen des Verbindungselementes 1 auftretenden Kraftlinienverläufe schematisch dargestellt. Aufgrund der symmetrischen Anordnung der Durchbrüche 9, 10, die zusätzliche Fixierpunkte auf den Leiterplatten darstellen, ergibt sich ein bezüglich der mittigen Querachse 8 symmetrischer Kraftlinienverlauf. Damit wird eine definierte Biegelinie entlang der Querachse 8 erhalten, ohne dass eine zusätzliche Bearbeitung des Grundkörpers 2 notwendig ist. Die Verformung des flexiblen Verbindungselementes 1 lässt sich also relativ genau vorherbestimmen.

Darüber hinaus bewirken die Lötverbindungen in den Durchbrüchen 9, 10 eine Entlastung der Lötflächen 5, 6 beim Verbiegen des Verbindungselementes 1. Insbesondere eine Belastung auf Scherung, die zum Aufbrechen einer Lötverbindung zwischen den Lötflächen 5, 6 und entsprechenden Anschlussflächen von Leiterplatten führen kann, wird so stark reduziert.

Durch die zwei Durchbrüche können also zwei zusätzliche Lötverbindungen bzw. Fixierpunkte zwischen dem flexiblen Verbindungselement und Leiterplatten hergestellt werden, die zum einen dafür sorgen, dass eine definierte, reproduzierbare Verformung des Verbindungselementes 1 erfolgt, und zum anderen eine Lötverbindung zwischen den Lötflächen 5, 6 des Grundkörpers 2 und den Leiterplatten entlasten.

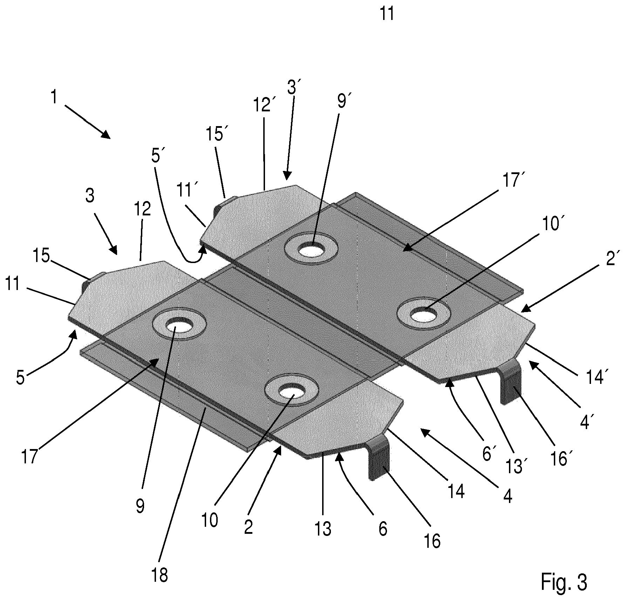

Figur 3 zeigt nun ein weiteres Ausführungsbeispiel des Verbindungselementes 1 in dreidimensionaler Darstellung. Dabei umfasst das flexible Verbindungselement 1 zwei Grundkörper 2, 2', die identisch aufgebaut. Dementsprechend sind die gleichen Bezugszeichen wie in den vorherigen Ausführungsbeispielen verwendet, wobei im zweiten Grundkörper 2' die Bezugszeichen gestrichen aufgeführt sind.

Im Unterschied zum Ausführungsbeispiel gemäß der Figuren 1 und 2 ist der Grundkörper 2 nicht genau rechteckig ausgebildet, sondern weist an seinen Enden 3, 3', 4, 4' winklig zusammenlaufende Kanten 11, 12, 13, 14, 11', 12', 13', 14' auf, läuft an seinen Enden 3, 4. 3', 4' also relativ spitz zusammen. Dabei sind an der Spitze, also dort, wo die Kanten 11, 12. 13, 14, 11', 12', 13', 14' zusammentreffen, Einsteckpins 15, 16, 15', 16' angeordnet, die einstückig mit dem Grundkörper 2 ausgebildet sind. Durch Umbiegen gegenüber dem Grundkörper 2 erstrecken sich die Einsteckpins 15, 16, 15', 16' senkrecht gegenüber dem Grundkörper 2 nach unten. Damit können die Einsteckpins 15, 16, 15', 16' in entsprechende Einstecköffnungen der Leiterplatten eingeführt werden und dort zur Fixierung dienen, aber gegebenenfalls auch einen zusätzlichen elektrischen Kontakt herstellen.

Ein mittlerer Bereich 17 der Grundkörper 2 ist mit einer Folie 18 bedeckt, wobei die Folie 18 die Grundkörper 2, 2' miteinander verbindet. Im Bereich der Durchbrüche 9, 10, 9', 10' weist die Folie 18 ebenfalls Öffnungen auf, sodass diese frei zugänglich bleiben.

Die Folie 18 dient dabei zum einen dazu, die Grundkörper 2, 2' miteinander zu verbinden und so leichter handhabbar zu machen, zum anderen dazu, den mittleren Bereich 17, 17' der Grundkörper 2 nach außen elektrisch zu isolieren und vor mechanischen Beeinflussungen zu schützen.

Das erfindungsgemäße flexible Verbindungselement, das auch als Flachleiterverbinder oder Jumper bezeichnet werden kann und also als oberflächenmontierbares Bauteil mit entsprechenden Oberflächenmontagetechniken (SMT) auf Leiterplatten montierbar ist, weist mindestens zwei Durchbrüche für zusätzliche Fixierpunkte bzw. Lötverbindungen auf, die gegenüber den eigentlichen Lötflächen des Grundkörpers nach innen versetzt sind. Dadurch tritt beim Verbiegen des Verbindungselementes eine symmetrische Kraftverteilung auf. Die Kraftlinien werden dabei so geführt, dass sie dafür sorgen, dass sich das Verbindungselement sehr exakt und rekonstruierbar verformt. Darüber hinaus richten sich diese Verbindungselemente auch konstruktionsbedingt senkrecht auf. Dabei werden durch die Durchbrüche zusätzliche Lötverbindungen erhalten, die als weitere Fixierpunkte beim Verformen des Verbindungselementes ein Abscheren der Hauptlötverbindung an den Lötflächen verhindern. Neben der exakten rekonstruierbaren Verformung wird also eine bessere mechanische Stabilität erreicht.

Diese wird weiter verbessert, indem zusätzliche Einsteckpins an den Enden des Grundkörpers ausgebildet werden. Es werden also Lötflächen für die SMT-Montagetechnik mit zusätzlichen Einsteckpins, wie sie bei drahtgebundenen Bauelementen verwendet werden, kombiniert. Damit wird erreicht, dass die Verbindungselemente immer exakt auf der gewünschten Position bestückt werden und auch im flüssigen Lötzinn nicht aus ihrer Position schwimmen. Zusätzlich kann über die Einsteckpins ein weiterer elektrischer Kontakt hergestellt werden, was zu einer höheren Strombelastbarkeit des flexiblen Verbindungselementes führt. Beispielsweise können auch mehr als zwei Grundkörper nebeneinander angeordnet werden, die insbesondere über eine gemeinsame Folie miteinander verbunden sind.

### Bezugszeichenliste

### Bezugszeichenlisten

- 1: flexibles Verbindungselement
- 2: Grundkörper
- 3: Ende
- 4: Ende
- 5: Lötfläche
- 6: Lötfläche
- 7: Längsachse
- 8: Querachse
- 9: Durchbruch
- 10: Durchbruch
- 11: Kante
- 12: Kante
- 13: Kante
- 14: Kante
- 15: Einsteckpin
- 16: Einsteckpin
- 17: mittlerer Bereich
- 18: Folie

- d: Abstand

## Patentansprüche

1. Leiterplattenanordnung mit mindestens einem flexiblen Verbindungselement (1) und mit zwei durch einen Spalt getrennte Leiterplatten, der von dem Verbindungselement (1) überbrückt ist,
wobei das Verbindungselement (1) mindestens einen elektrisch leitfähigen Grundkörper (2) aufweist, der streifenförmig ausgebildet ist und in seinen Endbereichen (3, 4) jeweils eine Lötfläche (5, 6) aufweist,
wobei das Verbindungselement (1) mit jeweils einer Lötfläche (5, 6) auf einer der Leiterplatten verlötet ist und wobei im Grundkörper (2) zwei Durchbrüche (9, 10) ausgebildet sind, die auf einer Längsachse (7) des Grundkörpers (2) und beidseitig einer senkrecht zur Längsachse (7) verlaufenden Querachse (8) liegen,
**dadurch gekennzeichnet, dass** in den Durchbrüchen (9, 10) jeweils eine zusätzliche Lötverbindung ausgebildet ist.

2. Leiterplattenanordnung nach Anspruch 1, **dadurch gekennzeichnet, dass** die Längsachse (7) mittig zum Grundkörper (2) verläuft und die Durchbrüche (9, 10) im gleichen Abstand d zur Querachse (8) angeordnet sind, die mittig zum Grundkörper (2) verläuft.

3. Leiterplattenanordnung nach Anspruch 1 oder 2, **dadurch gekennzeichnet, dass** die Durchbrüche (9, 10) außerhalb der Lötflächen (5, 6) liegen.

4. Leiterplattenanordnung nach einem der vorhergehenden Ansprüche, **dadurch gekennzeichnet, dass** die Durchbrüche (9, 10) kreisförmig sind.

5. Leiterplattenanordnung nach einem der vorhergehenden Ansprüche, **dadurch gekennzeichnet, dass** ein mittlerer Bereich (17) des Grundkörpers (2) außerhalb der Lötflächen (5, 6) mit einer Folie (18) bedeckt ist, wobei die Folie (18) im Bereich der Durchbrüche (9, 10) Öffnungen aufweist.

6. Leiterplattenanordnung nach einem der vorhergehenden Ansprüche, **dadurch gekennzeichnet, dass** der Grundkörper (2) an seinen Enden (3, 4) jeweils mindestens einen Einsteckpin (15, 16) aufweist.

7. Leiterplattenanordnung nach Anspruch 6, **dadurch gekennzeichnet, dass** der Einsteckpin (15, 16) einstückig mit dem Grundkörper (2) ausgebildet ist.

8. Leiterplattenanordnung nach Anspruch 6 oder 7, **dadurch gekennzeichnet, dass** die Einsteckpins (15, 16) mit den Durchbrüchen (9, 10) auf einer Längsachse (7) liegen.

9. Leiterplattenanordnung nach einem der Ansprüche 6 bis 8, **dadurch gekennzeichnet, dass** die Einsteckpins (15, 16) in Einstecköffnungen, die in den Leiterplatten ausgebildet sind, eingeführt sind.

10. Leiterplattenanordnung nach einem der vorhergehenden Ansprüche, **dadurch gekennzeichnet, dass** Längsseiten des Grundkörpers (2) parallel zur Längsachse (7) verlaufen.

11. Leiterplattenanordnung nach einem der vorhergehenden Ansprüche, **dadurch gekennzeichnet, dass** der Grundkörper (2) an seinen Enden (3, 4) winklig zusammenlaufende Kanten (11, 12, 13, 14) aufweist.

12. Leiterplattenanordnung nach einem vorhergehenden Ansprüche, **dadurch gekennzeichnet, dass** die Lötverbindung zwischen den Lötflächen (5, 6) und den Anschlussflächen auf den Leiterplatten sowie in den Durchbrüchen (9, 10) mittels Schmelzlöten hergestellt sind.

13. Leiterplattenanordnung nach einem der vorhergehenden Ansprüche, **dadurch gekennzeichnet, dass** zwischen den Lötflächen und der Anschlussfläche eine Hauptlötverbindung ausgebildet ist, die den elektrischen Kontakt herstellt.

## Claims

1. Circuit card assembly with at least one flexible connection element (1) and two circuit boards separated by a gap, which is bridged by the connection element (1), wherein the connection element (1) has at least one electrically conductive base body (2) which is strip-shaped and in its end regions (3, 4) each have a soldering surface (5, 6), wherein the connection element (1) is soldered to a respective soldering surface (5, 6) on one of the circuit boards and wherein the base body (2) has two perforations (9, 10) formed on a longitudinal axis (7) of the base body (2). and on both sides of a perpendicular to the longitudinal axis (7) extending transverse axis (8), **characterized in that** in the perforations (9, 10) each have an additional solder connection.

2. Circuit card assembly according to claim 1, **characterized in that** the longitudinal axis (7) extends centrally to the base body (2) and the perforations (9, 10) are arranged at an equal distance d to the transverse axis (8), which extends centrally to the base body (2).

3. Circuit card arrangement according to claim 1 or 2, **characterized in that** the perforations (9, 10) lie outside the soldering surfaces (5, 6).

4. Circuit card assembly according to one of the preceding claims, **characterized in that** the perforations (9, 10) are circular.

5. Circuit card assembly according to one of the preceding claims, **characterized in that** a middle region (17) of the base body (2) outside the soldering surfaces (5, 6) is covered with a film (18), wherein the film (18) has openings in the region of the perforations (9, 10).

6. Circuit card assembly according to one of the preceding claims, **characterized in that** the base body (2) has at least one insertion pin (15, 16) at its ends (3, 4).

7. Circuit card assembly according to claim 6, **characterized in that** the insertion pins (15, 16) are formed integrally with the base body (2).

8. Circuit card assembly according to claim 6 or 7, **characterized in that** the insertion pins (15, 16) lie on a longitudinal axis (7) with the perforations (9, 10).

9. Circuit card assembly according to one of claims 6 to 8, **characterized in that** the insertion pins (15, 16) are introduced in insertion openings which are formed in the circuit boards.

10. Circuit card assembly according to one of the preceding claims, **characterized in that** longitudinal sides of the base body (2) run parallel to the longitudinal axis (7).

11. Circuit card assembly according to one of the preceding claims, **characterized in that** the base body (2) has angled converging edges (11, 12, 13, 14) at its ends (3, 4).

12. Circuit card assembly according to one of the preceding claims, **characterized in that** the solder connection between the soldering surfaces (5, 6) and the connection surfaces on the circuit boards and in the perforations (9, 10) are produced by means of melt soldering.

13. Circuit card assembly according to one of the preceding claims, **characterized in that** a main solder connection is formed between the soldering surfaces and the connection surface which establishes the electrical contact.

## Revendications

1. Ensemble de cartes de circuits imprimés avec au moins un élément de liaison flexible (1) et avec deux cartes de circuits imprimés séparées par une fente qui est enjambée par l'élément de liaison (1),
dans lequel l'élément de liaison (1) comporte au moins un corps de base (2) électriquement conducteur qui est réalisé en forme de bande et qui comporte dans ses zones terminales (3, 4) à chaque fois une surface de brasage (5, 6),
dans lequel l'élément de liaison (1) est brasé avec à chaque fois une surface de brasage (5, 6) sur l'une des cartes de circuits imprimés et dans lequel sont réalisés dans le corps de base (2) deux trous (9, 10) qui se trouvent sur un axe longitudinal (7) du corps de base (2) et des deux côtés d'un axe transversal (8) qui s'étend perpendiculairement à l'axe longitudinal (7),
**caractérisé en ce qu'**une liaison par brasage supplémentaire est réalisée à chaque fois dans les trous (9, 10).

2. Ensemble de cartes de circuits imprimés selon la revendication 1, **caractérisé en ce que** l'axe longitudinal (7) s'étend au centre par rapport au corps de base (2) et les trous (9, 10) sont disposés à égale distance d de l'axe transversal (8) qui s'étend au centre par rapport au corps de base (2).

3. Ensemble de cartes de circuits imprimés selon la revendication 1 ou 2, **caractérisé en ce que** les trous (9, 10) se trouvent en dehors des surfaces de brasage (5, 6).

4. Ensemble de cartes de circuits imprimés selon l'une quelconque des revendications précédentes, **caractérisé en ce que** les trous (9, 10) sont ronds.

5. Ensemble de cartes de circuits imprimés selon l'une quelconque des revendications précédentes, **caractérisé en ce qu'**une zone centrale (17) du corps de base (2) en dehors des surfaces de brasage (5, 6) est recouverte d'une feuille (18), laquelle feuille (18) présente des ouvertures dans la zone des trous (9, 10).

6. Ensemble de cartes de circuits imprimés selon l'une quelconque des revendications précédentes, **caractérisé en ce que** le corps de base (2) comporte à ses extrémités (3, 4) à chaque fois au moins une broche enfichable (15, 16).

7. Ensemble de cartes de circuits imprimés selon la revendication 6, **caractérisé en ce que** la broche enfichable (15, 16) est réalisée d'une seule pièce avec le corps de base (2).

8. Ensemble de cartes de circuits imprimés selon la revendication 6 ou 7, **caractérisé en ce que** les broches enfichables (15, 16) se trouvent avec les trous (9, 10) sur un axe longitudinal (7).

9. Ensemble de cartes de circuits imprimés selon l'une quelconque des revendications 6 à 8, **caractérisé en ce que** les broches enfichables (15, 16) sont introduites dans des ouvertures d'enfichage qui sont réalisées dans les cartes de circuits imprimés.

10. Ensemble de cartes de circuits imprimés selon l'une quelconque des revendications précédentes, **caractérisé en ce que** les côtés longs du corps de base (2) s'étendent parallèlement à l'axe longitudinal (7).

11. Ensemble de cartes de circuits imprimés selon l'une quelconque des revendications précédentes, **caractérisé en ce que** le corps de base (2) présente à ses extrémités (3, 4) des arêtes (11, 12, 13, 14) qui convergent en angles.

12. Ensemble de cartes de circuits imprimés selon l'une quelconque des revendications précédentes, **caractérisé en ce que** les liaisons brasées entre les surfaces de brasage (5, 6) et les surfaces de raccordement sur les cartes de circuits imprimés ainsi que dans les trous (9, 10) sont fabriquées au moyen d'un brasage par fusion.

13. Ensemble de cartes de circuits imprimés selon l'une quelconque des revendications précédentes, **caractérisé en ce qu'**une liaison brasée principale qui établit le contact électrique est réalisée entre les surfaces de brasage et la surface de raccordement.
